# EUROPEAN PATENT APPLICATION

(11) **EP 3 379 578 A1**
(43) Date of publication of application: **26.09.2018**
(21) Application number: 18153174.0
(22) Date of filing: 24.01.2018
(51) Int. Cl.: H01L 29/423, H01L 29/778, H01L 23/29, H01L 29/20

(54) **SEMICONDUCTOR DEVICE**

(30) Priority: 21.03.2017 JP 2017054496
(71) Applicant: KABUSHIKI KAISHA TOSHIBA, Minato-ku Tokyo 105-8001 (JP); Toshiba Infrastructure Systems & Solutions Corporation, Kawasaki-shi, Kanagawa 212-8585 (JP)
(72) Inventor: Matsushita, Keiichi, Tokyo, 105-8001 (JP)
(74) Representative: Hoffmann Eitle

(57) **Abstract**

A semiconductor device (1,2) includes a semiconductor layer (13) provided on a substrate (10), a drain electrode (30) and a source electrode (40) provided on the semiconductor layer, and a gate electrode (20) provided on the semiconductor layer such that an angle between a lateral surface and the semiconductor layer gradually decreases toward the semiconductor layer.

## Description

### FIELD

Embodiments described herein relate generally to a semiconductor device.

### BACKGROUND

As a semiconductor device employed in a communication apparatus or the like (such as a high-electron-mobility transistor (HEMT)), a gallium nitride semiconductor device is known in the art. The gallium nitride semiconductor device has a semiconductor layer, various electrodes such as a gate electrode provided on the semiconductor layer, and an insulation layer. The gallium nitride semiconductor device has a higher dielectric strength than that of a silicon-based semiconductor device or a GaAs-based semiconductor device. For this reason, it is possible to increase an output power density by boosting an operating voltage of the semiconductor device.

When the operating voltage of the semiconductor device is boosted, an electric field intensity increases in the vicinity of an edge formed in a boundary between a bottom surface and a lateral surface of a gate electrode bonded to the semiconductor layer, so that a dielectric breakdown is generated between the gate electrode and the semiconductor layer in some cases. In this regard, a new sloped surface is provided between the lateral surface and the bottom surface of the gate electrode by chamfering the edge of the gate electrode. As a result, an angle of the edge formed by the bottom surface and the sloped surface of the gate electrode becomes larger than 90°, so that the electric field intensity in the vicinity of the edge is lowered. As a result, the dielectric breakdown generated between the gate electrode and the semiconductor layer is suppressed. Therefore, it is possible to increase a service life of the semiconductor device.

In order to suppress an electric field concentration in the vicinity of the edge formed by the bottom surface and the sloped surface of the electrode, it is necessary to reduce the angle between the sloped surface and the semiconductor layer at a certain level. Meanwhile, when the sloped surface is provided, an effective gate length of the gate electrode increases, so that a high-frequency characteristic of the semiconductor device is degraded.

### BRIEF DESCRIPTION OF THE DRAWINGS

FIG. 1 is a cross-sectional view illustrating a semiconductor device according to an embodiment of the invention;
FIG. 2 is a diagram illustrating the vicinity of a drain-side lateral surface of the gate electrode of FIG. 1;
FIG. 3 is a diagram illustrating a process of forming a surface protection layer on an AlGaN layer;
FIG. 4 is a diagram illustrating a process of forming a surface protection layer on an AlGaN layer;
FIG. 5 is a diagram illustrating a process of forming a surface protection layer on an AlGaN layer;
FIG. 6 is a diagram illustrating a process of forming a surface protection layer on an AlGaN layer;
FIG. 7 is a diagram illustrating a process of forming an opening in the surface protection layer;
FIG. 8 is a diagram illustrating a process of forming an opening in the surface protection layer;
FIG. 9 is a diagram illustrating a process of forming an opening in the surface protection layer;
FIG. 10 is a diagram illustrating a gate electrode according to an embodiment of the invention; and
FIG. 11 is a cross-sectional view illustrating a semiconductor device according to a modification of the embodiment of the invention.

### DETAILED DESCRIPTION

An exemplary semiconductor device according to an embodiment of the invention will now be described in details with reference to the accompanying drawings.

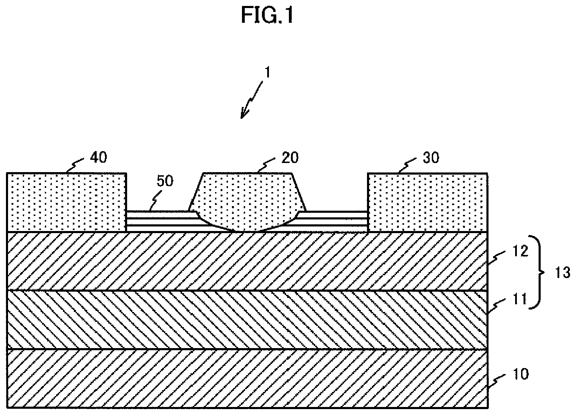

FIG. 1 is a cross-sectional view illustrating a semiconductor device 1 according to an embodiment of the invention. The semiconductor device 1 according to this embodiment includes a substrate 10, a compound semiconductor layer 13, a gate electrode 20, a drain electrode 30, a source electrode 40, and a surface protection layer 50.

The substrate 10 is, for example, a semi-insulating SiC substrate. The compound semiconductor layer 13 is formed on a top surface of the substrate 10 and includes a GaN layer 11 and an AlGaN layer 12.

The GaN layer 11 is an electron transport layer formed on the top surface of the substrate 10 using a gas mixture of a trimethyl gallium gas and an ammonia gas, for example, on the basis of a metal organic chemical vapor deposition (MOCVD) method.

The AlGaN layer 12 is an electron supply layer formed on the top surface of the GaN layer 11 by using a gas mixture of a trimethyl aluminum gas, a trimethyl gallium gas, and an ammonia gas as a source gas, for example, on the basis of the MOCVD method.

The GaN layer 11 and the AlGaN layer 12 have different bandgap energies. If semiconductor layers having different bandgap energies are bonded, electrons of the semiconductor layer serving as an electron supply layer and having lower electron affinity are collected in the semiconductor layer serving as the electron transport layer and having higher electron affinity. As a result, electrons are accumulated in the vicinity of the bonding surface (heterojunction interface) of the electron transport layer side so as to form a two-dimensional electron gas.

The two-dimensional electron gas has a state in which electrons are distributed in a planar shape of the semiconductor. Since the electrons distributed in a planar shape do not easily move in a vertical direction, a movement direction of the electrons is limited to a horizontal direction. For this reason, the electrons of the two-dimensional electron gas have high mobility.

The GaN layer 11 has electron affinity higher than that of the AlGaN layer 12. For this reason, the GaN layer 11 serves as an electron transport layer side.

As illustrated in FIG. 1, the gate electrode 20, the drain electrode 30, and the source electrode 40 are provided on the top surface of the AlGaN layer 12.

The gate electrode 20 is provided in the center of the AlGaN layer 12. The gate electrode 20 makes Schottky contact (bonding) with the AlGaN layer 12. In the Schottky contact, a resistance is different between when electrons flow from the gate electrode 20 to the AlGaN layer 12 and when electrons flow from the AlGaN layer 12 to the gate electrode 20. A shape of the gate electrode 20 or a method of forming the gate electrode 20 will be described below.

The drain electrode 30 is provided in one of the outer ends of the top surface of the AlGaN layer 12. The drain electrode 30 is formed by depositing, for example, titanium and aluminum on the AlGaN layer 12.

The source electrode 40 is provided in the outer end of the top surface of the AlGaN layer 12 by interposing the gate electrode 20 between the source electrode 40 and the drain electrode 30. The source electrode 40 is formed by depositing, for example, titanium and aluminum on the AlGaN layer 12. The source electrode 40 makes ohmic contact with the AlGaN layer 12.

The gate electrode 20 and the drain electrode 30 are spaced from each other, and the gate electrode 20 and the source electrode 40 are spaced from each other.

During operation of the semiconductor device 1, electrons move from the source electrode 40 to the drain electrode 30 through the two-dimensional electron gas layer formed under the AlGaN layer.

The surface protection layer 50 which is an SiN layer serving as an insulation layer is formed on the top surface of the AlGaN layer 12 exposed between the source electrode 40 and the gate electrode 20 and between the gate electrode 20 and the drain electrode 30. The surface protection layer 50 terminates a dangling bond to protect a surface of the AlGaN layer 12 from moisture or the like.

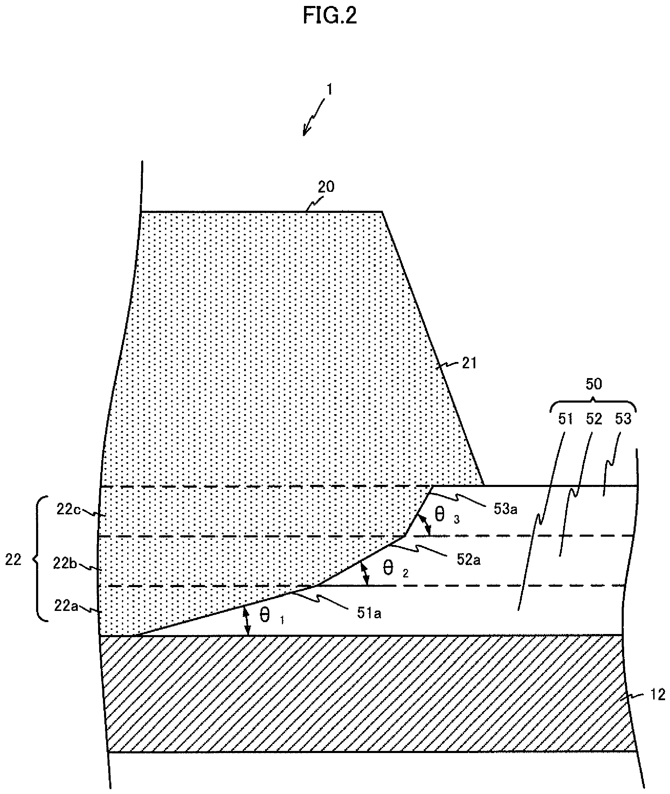

FIG. 2 is a diagram illustrating the vicinity of the lateral surface of the gate electrode 20. As illustrated in FIG. 2, the surface protection layer 50 includes a first insulation layer 51, a second insulation layer 52, and a third insulation layer 53 having different etching rates.

The first insulation layer 51 is a SiN layer formed on the top surface of the AlGaN layer 12 with a predetermined etching rate.

The second insulation layer 52 is a SiN layer formed on the top surface of the first insulation layer 51 with an etching rate higher than that of the first insulation layer 51.

The third insulation layer 53 is a SiN layer formed on the top surface of the second insulation layer 52 with an etching rate higher than that of the second insulation layer 52.

The gate electrode 20 includes a head portion 21 formed in an upper half of the gate electrode 20, and a stem portion 22 formed in a lower half of the gate electrode 20. The head portion 21 has a substantially trapezoidal cross-sectional shape.

The stem portion 22 has a first slope portion 22a, a second slope portion 22b, and a third slope portion 22c.

The first slope portion 22a is provided in a lower end of the stem portion 22 and joins with the AlGaN layer 12.

Both lateral surfaces of the first slope portion 22a are sloped surfaces respectively inclined to the AlGaN layer 12. The first slope portion 22a is tapered such that its diameter is narrowed toward the lower end of the stem portion 22. An angle θ₁ between the sloped surface of the first slope portion 22a and a surface parallel to the top surface of the AlGaN layer 12 is smaller than 90°.

The second slope portion 22b is provided on the first slope portion 22a, and the lower end of the second slope portion 22b is connected to an upper end of the first slope portion 22a.

Both lateral surfaces of the second slope portion 22b are sloped surfaces respectively inclined to the AlGaN layer 12. The second slope portion 22b is tapered such that its diameter is narrowed toward the lower end of the stem portion 22. An angle θ₂ between the sloped surface of the second slope portion 22b and a surface parallel to the top surface of the AlGaN layer 12 is larger than the angle θ₁ of the first slope portion 22a.

The third slope portion 22c is provided on the second slope portion 22b, and a lower end of the third slope portion 22c is connected to an upper end of the second slope portion 22b.

Both lateral surfaces of the third slope portion 22c are sloped surfaces respectively inclined to the AlGaN layer 12. The third slope portion 22c is tapered such that its diameter is narrowed toward the lower end of the stem portion 22. An angle θ₃ between the sloped surface of the third slope portion 22c and a surface parallel to the top surface of the AlGaN layer 12 is larger than the angle θ₂ of the second slope portion 22b.

The stem portion 22 is formed in a tapered shape whose taper angle decreases stepwise toward the lower end. According to this embodiment, the taper angle is an angle between a lateral surfaces on a cross section of the stem portion 22 and a surface parallel to the top surface of the AlGaN layer.

In general, if a sloped surface is provided between the bottom surface and the lateral surface of the stem portion 22 by chamfering an edge formed by the bottom surface and the lateral surface of the stem portion 22, it is possible to attenuate concentration of the electric field in the vicinity of the boundary between the bottom surface and the lateral surface of the stem portion 22.

In the semiconductor device 1 according to this embodiment, the angle θ₁ of the first slope portion 22a bonded to the AlGaN layer 12 is smaller than 90°. Therefore, it is possible to attenuate concentration of electric fields in the vicinity of the boundary between the bottom surface and the lateral surface of the stem portion 22.

For this reason, using the semiconductor device 1 according to this embodiment, it is possible to improve a dielectric strength.

If a voltage is applied to the gate electrode 20, an electron concentration of the two-dimensional electron gas under the bonding surface between the gate electrode 20 and the AlGaN layer 12 changes.

The gate length of the semiconductor device 1 is a width of the bonding surface between the gate electrode 20 and the AlGaN layer 12. If a gate length of the semiconductor device 1 increases, a movement distance of electrons increases, so that a high-frequency characteristic is degraded.

However, if the angle between the sloped surface of the stem portion 22 and the AlGaN layer 12 is small, a distance between the AlGaN layer 12 and the sloped surface of the stem portion 22 is reduced. For this reason, if a voltage is applied to the gate electrode 20, the electron concentration of the two-dimensional electron gas changes even under the surface near the bonding surface between the AlGaN layer 12 and the stem portion 22. That is, the effective gate length becomes longer than the width of the bonding surface between the gate electrode 20 and the AlGaN layer 12.

In the semiconductor device 1 according to this embodiment, the angle θ₂ of the second slope portion 22b and the angle θ₃ of the third slope portion 22c are larger than the angle θ₁ of the first slope portion 22a. For this reason, the distance between the AlGaN layer 12 and the sloped surface of the stem portion 22 increases toward both lateral ends of the stem portion 22.

As a result, a change of the electron concentration of the two-dimensional electron gas under the surface near the bonding surface between the AlGaN layer 12 and the stem portion 22 is suppressed. For this reason, using the semiconductor device 1, an increase of the effective gate length is suppressed.

Therefore, in the semiconductor device 1 according to this embodiment, degradation of the high-frequency characteristic is suppressed.

A method of manufacturing the gate electrode 20 of the semiconductor device 1 according to an embodiment of the invention will now be described.

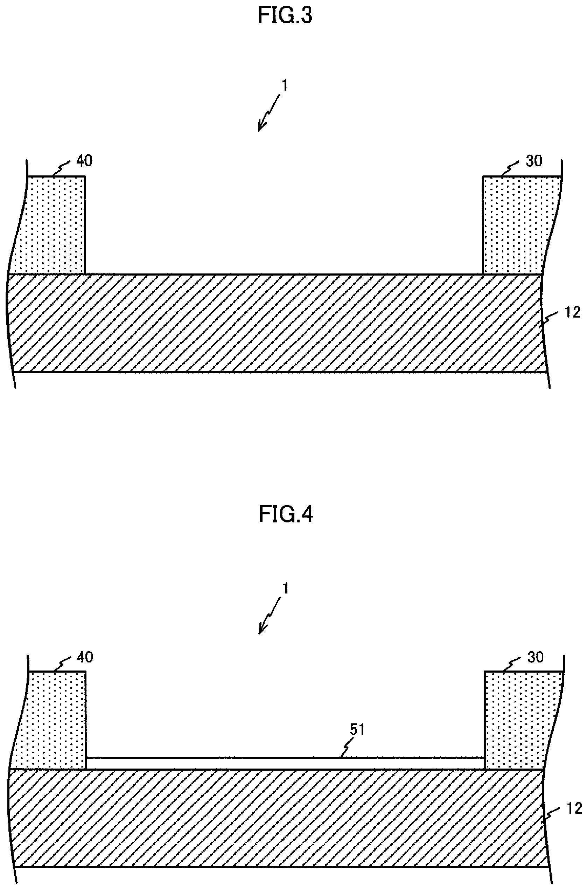

FIGS. 3 to 8 are diagrams illustrating a process of forming the surface protection layer 50 on the top surface of the AlGaN layer 12. As illustrated in FIG. 3, the drain electrode 30 and the source electrode 40 are provided on the top surface of the AlGaN layer 12. The surface protection layer 50 is formed on the top surface of the AlGaN layer 12 exposed between the drain electrode 30 and the source electrode 40.

A plasma-enhanced chemical vapor deposition (PECVD) method is employed to form the surface protection layer 50. The surface protection layer 50 which is a SiN layer is formed by a vapor phase reaction of silicon ions or nitrogen ions on the top surface of the AlGaN layer 12 by using a silane gas (SiH₄) and an ammonia gas (NH₃) as a source gas.

The vapor phase reaction of silicon ions or nitrogen ions on the top surface of the AlGaN layer 12 is performed in three separate steps. A flow ratio between the silane gas and the ammonia gas employed in the vapor phase reaction is different every time. Since the etching rate of the SiN layer is different depending on the flow ratio between the silane gas and the ammonia gas, the surface protection layer 50 has three SiN layers having different etching rates.

As illustrated in FIG. 4, in a first film formation, the first insulation layer 51 which is a SiN layer is formed on the top surface of the AlGaN layer 12 exposed between the drain electrode 30 and the source electrode 40 to cover the top surface of the AlGaN layer 12.

In order to form the first insulation layer 51, a flow rate of the ammonia is adjusted such that a refractive index of the first insulation layer 51 becomes lower than 1.8. In general, the SiN layer having a high refractive index has a high etching rate.

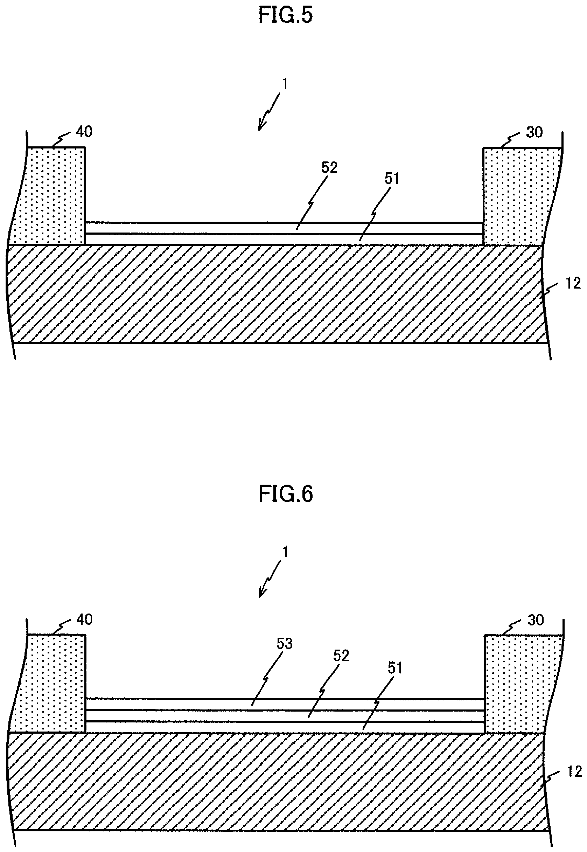

As illustrated in FIG. 5, in a second film formation, the second insulation layer 52 which is a SiN layer is formed on the top surface of the first insulation layer 51. In order to form the second insulation layer 52, the flow rate of the ammonia is adjusted such that the refractive index of the second insulation layer 52 becomes equal to or higher than 1.8 and lower than 2.0.

As illustrated in FIG. 6, in a third film formation, the third insulation layer 53 which is a SiN layer is formed on the top surface of the second insulation layer 52. In order to form the third insulation layer 53, the flow rate of the ammonia is adjusted such that the refractive index of the third insulation layer 53 becomes equal to or higher than 2.0.

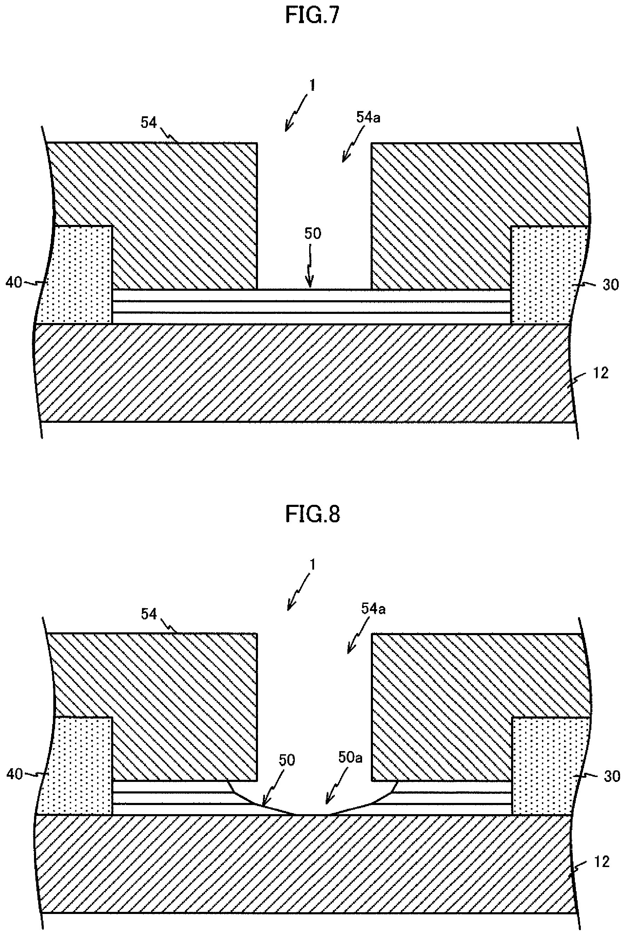

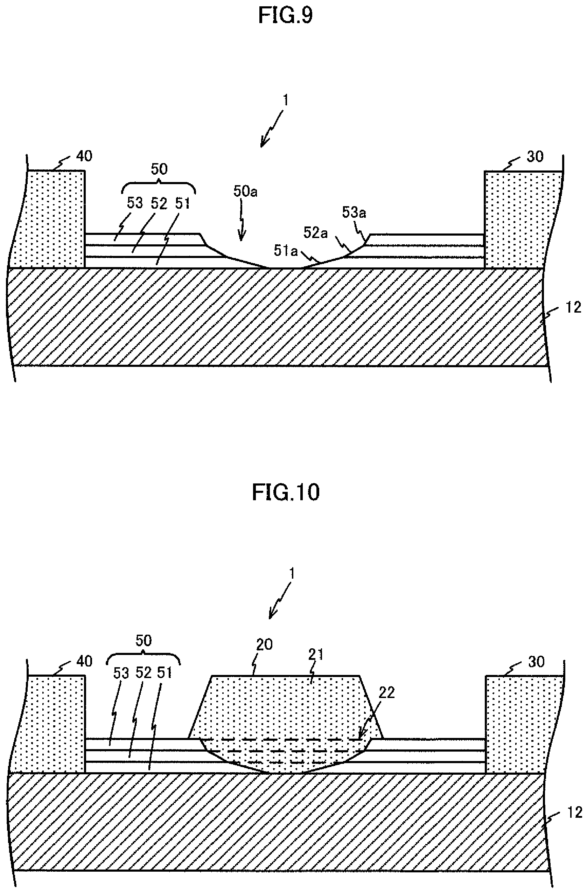

After the surface protection layer 50 is formed, an opening portion 50a of the surface protection layer 50 is formed. FIGS. 7 to 9 are diagrams illustrating a process of forming the opening portion 50a in the surface protection layer 50. As illustrated in FIG. 9, the lateral surface of the opening portion 50a includes a first lateral surface 51a, a second lateral surface 52a, and a third lateral surface 53a.

As illustrated in FIG. 7, a resist layer 54 having an opening 54a is formed.

As illustrated in FIG. 8, the surface protection layer 50 provided with the resist layer 54 on the top surface is subjected to wet etching using a hydrofluoric acid.

The third insulation layer 53 formed on the upper layer of the surface protection layer 50 is exposed from the opening 54a provided in the resist layer 54. In the wet etching process of the surface protection layer 50 using a hydrofluoric acid, the third insulation layer 53 is etched first to form an opening.

The third insulation layer 53 is etched downwardly and laterally from the surface exposed from the opening 54a. For this reason, the opening formed in the third insulation layer 53 is tapered such that an opening diameter increases toward the top surface of the third insulation layer 53.

As a result, the third insulation layer 53 is provided with an opening having the third lateral surface 53a inclined to the surface parallel to the top surface of the AlGaN layer 12. An angle between the third lateral surface 53a and the surface parallel to the top surface of the AlGaN layer 12 is the angle θ₃.

Then, the second insulation layer 52 is exposed from the opening formed in the third insulation layer 53 through the etching. The exposed second insulation layer 52 is also etched further. In addition, through the etching, the opening of the third insulation layer 53 is enlarged, and the exposed surface of the second insulation layer 52 is widened, so that etching is performed further.

As a result, the second insulation layer 52 has an opening provided with the second lateral surface 52a inclined to the surface parallel to the top surface of the AlGaN layer 12. The angle between the second lateral surface 52a and the surface parallel to the top surface of the AlGaN layer 12 is the angle θ₂.

The opening diameter of the upper end of the opening provided in the second insulation layer 52 becomes equal to the opening diameter of the lower end of the opening provided in the third insulation layer 53. For this reason, an increase rate of the opening diameter of the upper end of the opening provided in the second insulation layer 52 is equal to the increase rate of the opening diameter of the lower end of the opening provided in the third insulation layer 53.

Meanwhile, since the etching rate of the second insulation layer 52 is smaller than the etching rate of the third insulation layer 53, the etching rate of the second insulation layer 52 toward the AlGaN layer 12 is lower than the etching rate of the third insulation layer 53 toward the AlGaN layer 12. For this reason, the angle θ₂ of the second lateral surface 52a is smaller than the angle θ₃ of the third lateral surface 53a.

Finally, through the etching, the first insulation layer 51 is exposed from the opening provided in the second insulation layer 52. The exposed first insulation layer 51 is also etched further. In addition, through the etching, the opening of the second insulation layer 52 is enlarged, and the exposed surface of the first insulation layer 51 widened, so that the etching is performed further.

As a result, the first insulation layer 51 is provided with an opening having the first lateral surface 51a inclined to the surface parallel to the top surface of the AlGaN layer 12. The angle between the first lateral surface 51a and the surface parallel to the top surface of the AlGaN layer 12 is the angle θ₁.

The opening diameter of the upper end of the opening provided in the first insulation layer 51 becomes equal to the opening diameter of the lower end of the opening provided in the second insulation layer 52. For this reason, the increase rate of the opening diameter of the upper end of the opening provided in the first insulation layer 51 is equal to the increase rate of the opening diameter of the lower and of the opening provided in the second insulation layer 52.

Meanwhile, since the etching rate of the first insulation layer 51 is smaller than the etching rate of the second insulation layer 52, the etching rate of the first insulation layer 51 toward the AlGaN layer 12 is lower than the etching rate of the second insulation layer 52 toward the AlGaN layer 12. For this reason, the angle θ₁ of the first lateral surface 51a is smaller than the angle θ₂ of the second lateral surface 52a.

As described above, the angle θ₃ of the third lateral surface 53a is larger than the angle θ₂ of the second lateral surface 52a. In addition, the angle θ₂ of the second lateral surface 52a is larger than the angle θ₁ of the first lateral surface 51 a.

The lateral surfaces of the opening portion 50a includes the first lateral surface 51a, the second lateral surface 52a, and the third lateral surface 53a sequentially formed from the bottom. For this reason, the opening portion 50a becomes a tapered opening having a taper angle decreasing stepwise toward the lower surface of the surface protection layer 50.

As illustrated in FIG. 9, after the opening portion 50a is formed in the surface protection layer 50, the resist layer 54 is removed. As illustrated in FIG. 10, after the resist layer 54 is removed, for example, nickel and gold are deposited on the opening portion 50a to form the gate electrode 20. The lateral surface of the stem portion 22 is formed along the lateral surface of the opening portion 50a.

Returning to FIG. 2, the lateral surface of the first slope portion 22a is formed along the first lateral surface 51a. For this reason, the angle between the lateral surface of the first slope portion 22a and the surface parallel to the top surface of the AlGaN layer 12 becomes equal to the angle θ₁ of the first lateral surface 51 a.

Similar to the first slope portion 22a, the lateral surface of the second slope portion 22b is formed along the second lateral surface 52a. For this reason, the angle between the lateral surface of the second slope portion 22b and the surface parallel to the top surface of the AlGaN layer 12 becomes equal to the angle θ₂ of the second lateral surface 52a.

In addition, the lateral surface of the third slope portion 22c is also formed along the third lateral surface 53a. For this reason, the angle between the lateral surface of the third slope portion 22c and the surface parallel to the top surface of the AlGaN layer 12 becomes equal to the angle θ₃ of the third lateral surface 53a.

As a result, the stem portion 22 is tapered such that the taper angle decreases stepwise downward.

In this manner, the angle θ₁ of the first slope portion 22a is determined by the etching rate of the first insulation layer 51. Similarly, the angle θ₂ of the second slope portion 22b is determined by the etching rate of the second insulation layer 52, and the angle θ₃ of the third slope portion 22c is also determined by the etching rate of the third insulation layer 53.

Therefore, the shape of the stem portion 22 can be determined by selecting the etching rates of the first, second, and third insulation layers 51, 52, and 53.

As described above, in the semiconductor device 1 according to this embodiment, it is possible to arbitrarily control the shape of the opening portion 50a formed in the surface protection layer 50 through etching by overlapping a plurality of SiN layers having different etching rates. In addition, it is possible to arbitrarily control the shape of the stem portion 22 by controlling the shape of the opening portion 50a.

By forming the lateral surface of the stem portion 22 such that the taper angle decreases stepwise downward, it is possible to improve a dielectric strength without degrading a high-frequency characteristic of the semiconductor device 1. In the semiconductor device according to this embodiment, since the dielectric strength is improved without degrading the high-frequency characteristic, it is possible to provide high reliability even in a high-temperature operation in which a dielectric breakdown easily occurs.

### <Modification>

Next, a semiconductor device 2 according to a modification of the embodiment will be described. The semiconductor device 2 is different from the semiconductor device 1 in the method of forming the surface protection layer and the shape of the gate electrode.

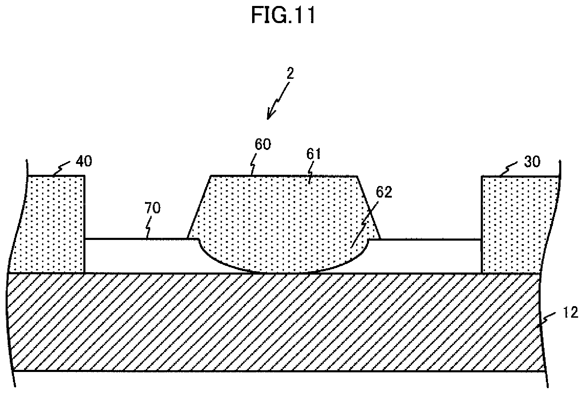

FIG. 11 is a diagram illustrating a modification of the semiconductor device 1. As illustrated in FIG. 11, the semiconductor device 2 includes an AlGaN layer 12, a gate electrode 60, a drain electrode 30, a source electrode 40, and a surface protection layer 70.

A plasma CVD method is employed to form the surface protection layer 70. The surface protection layer 70 which is a SiN layer is formed by a vapor phase reaction of silicon ions or nitrogen ions on the top surface of the AlGaN layer 12 by using a silane gas and an ammonia gas as a source gas.

When silicon ions or nitrogen ions are film formed on the top surface of the AlGaN layer 12, the flow ratio between the silane gas and the ammonia gas slowly changes. The etching rate of the SiN layer is different depending on the flow ratio between the silane gas and the ammonia gas.

The flow ratio between the silane gas and the ammonia gas is adjusted such that the etching rate of the surface protection layer 70 gradually decreases toward the AlGaN layer 12. For this reason, the etching rate of the surface protection layer 70 gradually decreases toward the AlGaN layer 12. The surface protection layer 70 is formed through a single deposition process.

A resist layer having an opening is formed on the top surface of the surface protection layer 70, and the surface protection layer 70 is subjected to wet etching using a hydrofluoric acid. As illustrated in FIG. 11, a lateral surface of the opening provided in the surface protection layer 70 has a hemispherical shape.

After the resist layer is removed, for example, nickel and gold are deposited on the opening provided in the surface protection layer 70 to form the gate electrode 60. The gate electrode 60 has a head portion 61 formed in an upper half of the gate electrode 60 and a stem portion 62 formed in a lower half of the gate electrode 60.

The lateral surface of the stem portion 62 is formed along the lateral surface of the opening provided in the surface protection layer 70. As a result, the stem portion 62 is formed in a hemispherical shape.

The surface protection layer 70 may be formed in a single deposition process. In addition, by forming the stem portion 62 in a hemispherical shape, it is possible to improve a dielectric strength without degrading a high-frequency characteristic of the semiconductor device 2.

While the embodiments of the invention have been described hereinbefore, they are not intended to limit the scope of the invention.

The semiconductor device according to the embodiment is a gallium nitride semiconductor device. Without limiting thereto, the semiconductor device may also be, for example, a silicon-based semiconductor device or a GaAs-based semiconductor device.

According to this embodiment, the surface protection layer 50 is a SiN layer, and the refractive indices of the first, second, and third insulation layers 51, 52, and 53 are set to be lower than 1.8, be equal to or higher than 1.8 and lower than 2.0, and be equal to or higher than 2.0, respectively. Without limiting thereto, the surface protection layer may be an insulation layer, the etching rate of the second insulation layer may be higher than that of the first insulation layer, and the etching rate of the third insulation layer may be higher than that of the second insulation layer.

According to this embodiment, the stem portion 22 is formed to have three slope portions including the first, second, and third slope portions 22a, 22b, and 22c. Without limiting thereto, the stem portion 22 may be formed to have four or more slope portions.

According to this embodiment, in order to increase the etching rate of the SiN layer, the flow rate of the ammonia gas is adjusted. Without limiting thereto, the flow rate of the silane gas may be adjusted to increase the etching rate of the SiN layer. In addition, when the plasma CVD method is employed, the plasma electric power may be adjusted to increase the etching rate of the SiN layer.

According to this embodiment, both lateral surfaces of the stem portion 22 are inclined. Without limiting thereto, since electric fields are concentrated on the drain electrode 30 side of the gate electrode 20, the first, second, and third slope portions 22a, 22b, and 22c may be shaped to have a slope in only the drain electrode 30 side.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions the accompanying claims and their equivalents are intended to cover such forms or modifications as would fall within the scope and spirit of the inventions.

## Claims

1. A semiconductor device (1,2) comprising:
a semiconductor layer (13) provided on a substrate (10);
a drain electrode (30) and a source electrode (40) provided on the semiconductor layer; and
a gate electrode (20) provided on the semiconductor layer such that an angle between a lateral surface and the semiconductor layer gradually decreases toward the semiconductor layer.

2. The semiconductor device according to claim 1, wherein
a plurality of insulation layers (51,52,53) having different etching rates are formed on the semiconductor layer exposed between the source electrode and the gate electrode and between the gate electrode and the drain electrode in ascending order of the etching rate.

3. The semiconductor device according to claim 2, wherein
the plurality of insulation layers are at least three insulation layers,
an opening portion (50) is formed such that an angle between a lateral surface and the semiconductor layer gradually decreases toward the semiconductor layer, and
the gate electrode is provided in the opening portion.

4. The semiconductor device according to claim 1, wherein
the insulation layer provided on the semiconductor layer exposed between the source electrode and the gate electrode and between the gate electrode and the drain electrode is formed such that the etching rate gradually decreases toward the semiconductor layer.

5. The semiconductor device according to claim 1, wherein
the semiconductor layer includes a GaN layer (11) and an AlGaN layer (12).

6. The semiconductor device according to claim 2, wherein
the plurality of insulation layers are SiN layers.

7. The semiconductor device according to claim 6, wherein
the plurality of insulation layers include first, second, and third insulation layers,
the first insulation layer (51) has a refractive index lower than 1.8,
the second insulation layer (52) has a refractive index equal to or higher than 1.8 and lower than 2.0, and
the third insulation layer (53) has a refractive index equal to or higher than 2.0.

8. The semiconductor device according to claim 4, wherein
the insulation layer is a SiN layer.

9. The semiconductor device according to claim 4, wherein
an opening portion (50) is formed in the plurality of insulation layers such that an angle between a lateral surface and the semiconductor layer gradually decreases toward the semiconductor layer, and
the gate electrode is provided in the opening portion.

10. The semiconductor device according to claim 1, wherein
the gate electrode is formed such that an angle between the lateral surface of the gate electrode on the drain electrode side and the semiconductor layer gradually decreases toward the semiconductor layer.
